(19) **Europäisches Patentamt / European Patent Office / Office européen des brevets**

(11) **EP 1 983 370 A1**

(12) # EUROPEAN PATENT APPLICATION
published in accordance with Art. 158(3) EPC

(43) Date of publication:
**22.10.2008 Bulletin 2008/43**

(51) Int Cl.:
**G03F 1/14** (2006.01)     **H01L 21/027** (2006.01)

(21) Application number: **07707738.6**

(22) Date of filing: **30.01.2007**

(86) International application number:
**PCT/JP2007/051520**

(87) International publication number:
**WO 2007/088862 (09.08.2007 Gazette 2007/32)**

(84) Designated Contracting States:
**DE**

(30) Priority: **01.02.2006 JP 2006024246**

(71) Applicant: **Mitsui Chemicals, Inc.**
**Tokyo 105-7117 (JP)**

(72) Inventors:
• **KONDOU, Masahiro**
**Kuga-gun, Yamaguchi 740-0061 (JP)**

• **NAKANO, Toshihiko**
**Kuga-gun, Yamaguchi 740-0061 (JP)**

(74) Representative: **HOFFMANN EITLE**
**Patent- und Rechtsanwälte**
**Arabellastrasse 4**
**81925 München (DE)**

(54) **PELLICLE FOR HIGH NUMERICAL APERTURE EXPOSURE DEVICE**

(57)     A pellicle that is used in a semiconductor lithography process and that can be used in an exposure device with an optical system having a numerical aperture of 1.0 or above, is provided. The pellicle of the present invention uses a pellicle film that has had its film thickness adjusted so as to exhibit transmittance of 95% or above at angles of incidence of exposure light with respect to the pellicle film in the range of from 0° to 20°. By using the pellicle of the present invention, it is possible to produce a semiconductor having an unprecedented fine circuit pattern at good yield while preventing adherence of dust to a reticle.

EP 1 983 370 A1

**Description**

Technical Field

The present invention relates to a pellicle used in semiconductor lithography, which is a dust-proof cover that prevents dust from adhering to a reticle or photomask (hereinafter, simply referred to as a "reticle") and, further, relates to a pellicle that can be favorably used in an exposure device having a numerical aperture of 1.0 or higher.

Related Art

The manufacture of semiconductors includes a process known as lithography. In the lithography process, a reticle having a circuit pattern drawn thereon is irradiated with short wavelength light beams using an exposure device known as a stepper, and the circuit pattern is reduced and transferred onto a semiconductor wafer coated with a photoresist.

A frame of aluminum or the like (this frame is referred to as a "pellicle frame"), at which is provided a film made of cellulose, fluorine resin or the like (this film is referred to as a "pellicle film") is used as dust-proof cover that prevents dust from adhering to a reticle, and this dust-proof cover is known as a pellicle.

In addition to exhibiting a dust-proofing function, a pellicle used to prevent dust from adhering to a reticle must exert the minimum possible influence on optical systems and, specifically, must allow maximum possible transmittance of exposure light without reflection or absorption thereof.

The ratio of the size of the circuit pattern drawn on the reticle to the size of the circuit pattern reduced and transferred onto the semiconductor wafer is known as the reduction factor. During the 1980s, the reduction factor was approximately 0.1; however, over time, it was reduced due to the need for positioning at high precision as a result of miniaturization of circuit patterns, and converged at 0.25 in the late 1990s.

The wavelength of exposure light is being shortened in order to draw yet finer circuit patterns, and reduction of wavelength has been underway from mercury lamp g-line (wavelength: 436 nm) to i-line (wavelength: 365 nm), KrF excimer laser (wavelength: 248 nm) and ArF excimer laser (wavelength: 193 nm). Pellicles using a fluorine resin in the pellicle film (Japanese Patent Application Laid-Open (JP-A) No. 2001-255643) and pellicle films with increased film thickness (JP-A No. 2000-347388), for example, are known as pellicles that are compatible with a short wavelength light source, as are pellicles that can be used at two different wavelengths (JP-A No. 7-199451) and the like. However, with respect to the F2 excimer laser (wavelength: 157 nm) that is currently regarded as the next-generation light source, the development of various parts and materials for use in the exposure device is overdue and, at present, no prospects of actual use have yet emerged.

In the miniaturization of circuit patterns, in addition to the above-mentioned shortening of the exposure light wavelength, a method exists of increasing the numerical aperture of the projection lens of an exposure device.

An immersion technique of filling the space between an object of observation and the objective lens of a microscope with a liquid having a high refractive index has long been known as a technique for improving the resolution of an optical microscope. As disclosed in, for example, JP-A Nos. 7-220990 and 10-303114, devices using an immersion exposure technique have, at long last, also been developed in semiconductor lithography.

Use of the immersion exposure technique makes it possible to increase the numerical aperture of the optical system of an exposure device and to increase the resolution of the circuit pattern. The numerical aperture (NA) is defined by the following equation:

$$NA^{'} = n \times \sin\theta$$

In the equation, n is the refractive index of the medium through which the exposure light is transmitted and $\theta$ is the maximum angle of incidence of the exposure light. Here, the angle of incidence is the angle formed with a normal line from the point of incidence. In other words, the angle of incidence is 0° when light is incident perpendicular to the surface of incidence, and the angle of incidence is almost 90° when light is incident nearly parallel to the surface of incidence.

Since the refractive index of air is 1, the numerical aperture value is 1 or below when exposure is performed in an air atmosphere; however, a numerical aperture of 1 or above can be realized by filling the space between the semiconductor wafer and the projection lens of an exposure device with a liquid having a high refractive index.

In conventional exposure devices that perform exposure in an air atmosphere, steppers with a numerical aperture of 0.84 have been widely used; however, as exposure devices employing the immersion exposure technique, immersion steppers with a numerical aperture of 1.07 are about to become commercially available and, moreover, immersion steppers with a numerical aperture of around 1.2 are under development.

In addition, recently, by way of contrast with immersion exposure, conventional exposure performed in an air atmosphere is sometimes referred to as dry exposure.

Patent Document 1: JP-A No. 2001-255643
Patent Document 2: JP-A No. 2000-347388
Patent Document 3: JP-A No. 7-199451
Patent Document 4: JP-A No. 7-220990
Patent Document 5: JP-A No. 10-303114

Exposure devices such as the steppers used in a semiconductor lithography process radiate exposure light generated by a light source onto a reticle, and reduce and transfer a circuit pattern formed on the reticle onto the semiconductor wafer. In the foregoing, it is explained how the ratio of the size of the circuit pattern on the reticle to the size of the circuit pattern reduced and transferred onto the semiconductor wafer is known as the reduction factor; however, the reduction factor can also be defined using the numerical aperture of the optical system of the exposure device.

The exposure light generated by the light source in an exposure device is collected by a collection optical system so as to converge the focal point at a position on the reticle, and is then collected again so as to converge the focal point on the semiconductor wafer. Here, the optical system for converging the focal point at a position on the reticle is known as a collection system or a collection optical system, and the optical system for converging the focal point on the semiconductor wafer is known as an imaging system or an imaging optical system.

When the numerical aperture of the collection system is NAr, the numerical aperture of the imaging system is NAw and the reduction factor is $1/\beta$,

$$NAr / NAw = 1/\beta$$

Since this relationship is universally applicable to optical systems, it is said to be the optical invariant.

DISCLOSURE OF THE INVENTION

Problem to be solved by the Invention

To provide a pellicle that can be used in an exposure device that has achieved miniaturization of a circuit pattern by increasing the numerical aperture of collection optics.

Means for solving the Problems

The present inventors increased the numerical aperture of collection optics by changing the value of angle of incidence $\theta$ of the exposure device light source and found a pellicle having high light beam transmittance even when the value of the angle of incidence is changed.

In other words, the present invention relates to the following.

(1) A pellicle (dust-proof cover) used in semiconductor lithography including a pellicle film (dust-proof film) attached to a frame, the pellicle being for use in an exposure device having a numerical aperture of not less than 1.0, wherein the pellicle has light transmittance at a wavelength of an exposure light source of 95% or more, at angles of incidence with respect to the pellicle film of from 0° to 20°.

(2) In (1), the wavelength of the exposure light source is preferably 200 nm or less.

(3) The thickness of the pellicle film of the pellicle described in (1) or (2) preferably satisfies the following Equations (1)-(4):

$$\text{Equation (1): } \delta = 2\Pi \cdot n \cdot d \cdot \cos\theta / \lambda$$

$$\text{Equation (2): } T = 16n^2 / \{(1+n)^4 + (1-n)^2(n-1)^2 - 2(n-1)^2(1+n)^2 \cos 2\delta\}$$

$$\text{Equation (3): } T \geq 95$$

$$\text{Equation (4): } 0 \le \theta \le 20$$

T: transmittance (%)
d: pellicle film thickness (nm)
$\lambda$: wavelength of light source for exposure (nm)
n: refractive index of pellicle film
$\theta$: angle of incidence (°).

(4) The pellicle film of the pellicle described in (1) to (3) is preferably non-crystalline fluorine resin.

(5) The exposure light source of the exposure device using the pellicle described in (1) to (4) is preferably ArF excimer laser.

(6) A pellicle having a pellicle film having a refractive index of 1.34 and a film thickness of 558 nm $\pm$ 15 nm is preferably used in the exposure device described in (5).

(7) The exposure device using the pellicle described in (1) to (6) is preferably an immersion exposure device.

Effects of the Invention

Due to the accomplishment of the present invention, it is possible to provide a pellicle that has high light beam transmittance even when the value of the angle of incidence of an exposure device light source is changed. As a result, it is possible to increase the numerical aperture of a collection optical system of an exposure device and to realize miniaturization of a circuit pattern.

Brief Explanation of the Drawings

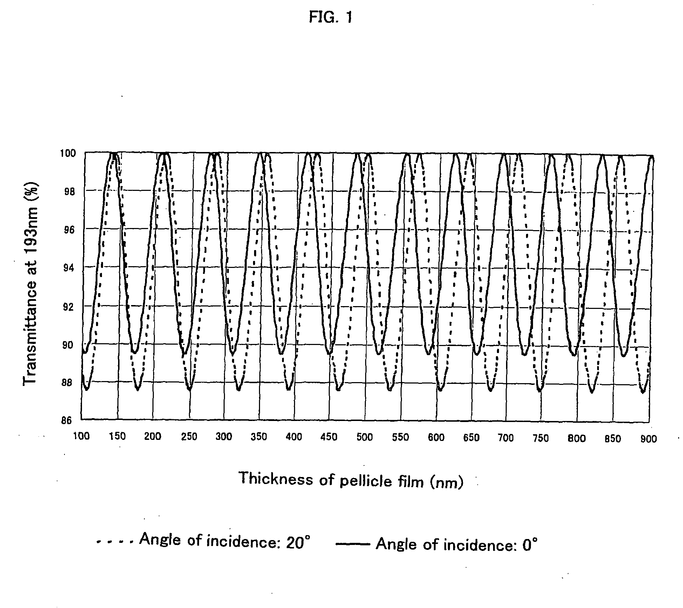

Fig. 1 shows the relationship between the light transmittance and the thickness of a pellicle film satisfying both Equations (1) and (2) when the refractive index is 1.34 and the wavelength of the light source for exposure is 193 nm, at angles of incidence of 0° and 20°.

Best Mode of Practicing the Invention

A material with which high light beam transmittance can be obtained when formed into a thin film, is used as the material for the pellicle film. Further, a material that does not easily absorb exposure light is preferable. If the pellicle film material absorbs exposure light, the light beam transmittance is reduced and, moreover, chemical bondings in the pellicle film material are severed and the pellicle film material deteriorates, leading to reduced longevity of the pellicle, which is undesirable. Specific examples include cellulose and fluorine resins, and fluorine resins are particularly preferably used since they have high light beam transmittance and superior film forming properties.

Commonly-used methods of film production may be used in the production of the pellicle film. Normally, the substance that provides the material for the pellicle film is dissolved in a solvent to form a solution, and the pellicle film is produced by a method such as spin-coating.

The pellicle film preferably has high light beam transmittance with respect to any angle of incidence of light on the pellicle film and, specifically, a light beam transmittance of 95% or higher is preferable. In particular, the light beam transmittance is preferably 95% or higher when the angle of incidence is from 0° to 20°.

In conventionally-used dry exposure steppers, the numerical aperture of the imaging optical system NAw is 0.84 and the reduction factor $1/\beta$ is 1/4; and the numerical aperture of the collection optical system NAr is 0.21, since NAr/0.84 = 1/4. Since the refractive index of air is 1, $\sin\theta$ = 0.21 and, consequently, the maximum angle of incidence $\theta$ of the collection optical system is 12.1°. Further, in the present application the refractive index is a value measured with an Abbe refractometer.

On the other hand, in a stepper in which the numerical aperture of the imaging optical system NAw is 1.2, when the reduction factor $1/\beta$ is 1/4, the maximum angle of incidence $\theta$ of the collection optical system calculated in a similar manner is 17.5°. Accordingly, when using a stepper with a large numerical aperture, the light beam transmittance should be increased, particularly at angles of incidence of from 0° to 20°.

A pellicle film having high light beam transmittance can be obtained when the thickness of the film satisfies the following Equations (1)-(4).

$$\text{Equation (1): } \delta = 2\Pi \cdot n \cdot d \cdot \cos\theta/\lambda$$

$$\text{Equation (2): } T = 16n^2/\{(1+n)^4+(1-n)^2(n-1)^2-2(n-1)^2(1+n)^2\cos 2\delta\}$$

$$\text{Equation (3): } T \geq 95$$

$$\text{Equation (4): } 0 \leq \theta \leq 20$$

T: transmittance (%)
d: pellicle film thickness (nm)
$\lambda$: wavelength of light source for exposure (nm)
n: refractive index of pellicle film
$\theta$: angle of incidence (°)

A pellicle film which satisfies Equations (1)-(4) and which is of a thickness that can maintain the necessary strength is used. When a film having a small thickness is used as a pellicle, there is a risk that film strength cannot be maintained and that the film will tear and the workability at the time of pellicle manufacture and exposure be reduced. Further, there is a risk that variations in the thickness of the pellicle film will exert a significant influence. When film thickness is large, there is a risk that absorption of light by the material used in the pellicle film will have an influence and that appropriate light beam transmittance cannot be obtained. The film thickness satisfying Equations (1)-(4) may be selected according to the type of material used in the pellicle film.

In order to draw finer circuit patterns, a light source having a short wavelength is preferably used as the light source of the exposure device. Examples thereof include KrF excimer laser (wavelength: 248 nm), ArF excimer laser (wavelength: 193 nm) and F2 excimer laser (wavelength: 157 nm). A light source having a wavelength of 200 nm or less is preferably used and ArF excimer laser (wavelength: 193 nm) is particularly preferably used.

Specific examples of pellicle films that can be preferably used include pellicle films having a refractive index of 1.34 and a film thickness of in the range of 558 nm±15 nm. The range of the film thickness here means that the thickness at every point on the pellicle film is within the stated range.

Fig. 1 shows the relationship between the light transmittance and the thickness of a pellicle film satisfying both Equations (1) and (2), when the refractive index is 1.34 and the wavelength of the light source for exposure is 193 (nm) at angles of incidence of 0° and 20°.

An antireflection film may be provided at one surface or both surfaces of the pellicle film in order to reduce reflection of light at the pellicle film surface. When there is a large amount of light reflection at the pellicle film surface, light beam transmittance may decrease and, moreover, there is a risk that the reflected light will become stray light inside the exposure device, reducing the contrast of the of the circuit pattern transferred onto the semiconductor wafer and thus reducing the yield of the semiconductor element, which is undesirable.

When there is an increase in light reflected by the pellicle film, there is a risk that stray light inside the optical system will increase and the contrast of the circuit pattern transferred onto the wafer will decrease.

A pellicle using the above kind of pellicle film is appropriate for use in an exposure device having a numerical aperture of 1.0 or higher. An immersion exposure technique is preferably applied in order to increase the numerical aperture.

EXAMPLES

The present invention will be explained in detail via presentation of the following examples and comparative examples, but the present invention is not limited thereto.

(Example 1)

Ethylcellulose manufactured by Dow Chemical Company (trade name: Ethocel) was dissolved in methyl isobutyl to prepare a 5 weight% solution thereof. The solution was filtered using a polytetrafluoroethylene membrane filter having a pore size of 500 nm to remove extraneous material. 20 ml of the solution was dripped onto a quartz glass substrate and, after spin-coating by rotating at 700 rpm for 30 seconds and drying in a clean oven at 150°C for 5 minutes, a foundation layer for ensuring the flatness of the pellicle film was formed on the quartz glass substrate. After cooling to room temperature, the film thickness of the foundation layer was found to be 1200 nm by measurement using a film thickness meter.

A 3.3 weight% solution of a fluorine resin manufactured by Asahi Glass Co., Ltd. (Cytop®; Grade S), used as the material for producing the pellicle film, was prepared using a fluorine solvent manufactured by Jemco, Inc. (Eftop®; EF-L174S), and filtration was performed using a polytetrafluoroethylene (PTFE) membrane filter having a pore size of 500 nm to remove extraneous material. 20 ml of the solution was dripped onto a quartz glass substrate having the ethylcellulose foundation thereon and, after spin-coating by rotating at a speed of 500 rpm for 150 seconds and drying in a clean oven at 180°C for 10 minutes, a pellicle film was formed.

Thereafter, a peeling ring made of resin having double-sided pressure-sensitive adhesive tape attached to one end surface thereof and having an outer diameter of 210 mm, an inner diameter of 170 mm and a height of 3 mm, was pressed and adhered to the pellicle film, and the pellicle film was peeled away from its interface with the foundation layer on the quartz glass substrate by raising the peeling ring.

The peeled-off pellicle film was attached to a pellicle frame. The thickness of the pellicle film was 558 nm.

(Example 2)

A pellicle film was prepared in the same manner as in Example 1 except that the concentration of the solution and the rotation speed when forming the pellicle film were adjusted so that the thickness of the pellicle film was 562 nm.

(Example 3)

A pellicle film was prepared in the same manner as in Example 1 except that the concentration of the solution and the rotation speed when forming the pellicle film were adjusted so that the thickness of the pellicle film was 352 nm.

(Example 4)

A pellicle film was prepared in the same manner as in Example 1 except that the concentration of the solution and the rotation speed when forming the pellicle film were adjusted so that the film thickness of the pellicle film was 282 nm.

(Example 5)

A pellicle film was prepared in the same manner as in Example 1 except that the concentration of the solution and the rotation speed when forming the pellicle film were adjusted so that the thickness of the pellicle film was 141 mm.

(Comparative Example 1)

A pellicle film was prepared in the same manner as in Example 1 except that the amount of the solution dripped and the rotation speed when forming the pellicle film were adjusted so that the thickness of the pellicle film was 591 nm.

(Comparative Example 2)

A pellicle film was prepared in the same manner as in Example 1 except that the concentration of the solution and the rotation speed when forming the pellicle film were adjusted so that the thickness of the pellicle film was 814 nm.

(Comparative Example 3)

A pellicle film was prepared in the same manner as in Example 1 except that the concentration of the solution and the rotation speed when forming the pellicle film were adjusted so that the thickness of the pellicle film was 320 nm.

(Comparative Example 4)

A pellicle film was prepared in the same manner as in Example 1 except that the concentration of the solution and the rotation speed when forming the pellicle film were adjusted so that the thickness of the pellicle film was 90 nm; however, when the pellicle film was peeled from the film-formation substrate, the pellicle film stretched and a part of the pellicle film tore.

Using the UV-visible spectrophotometer, UV-240 manufactured by Shimadzu Corporation, transmittance at a wavelength of 193 nm was measured while changing the angle of incidence with respect to the pellicle film. In Examples 1 and 2 and Comparative Examples 1 and 2, measurement was made at 10° intervals at angles of incidence of from 0° to 40°. In Examples 3, 4 and 5 and Comparative Example 3, measurement was made at 10° intervals at angles of incidence of from 0° to 40°. In Comparative Example 4, measurement was not possible as the pellicle film had torn. The results of the measurement are shown in Table 1.
Table 1

| | Thickness of pellicle film (nm) | Transmittance at 0° angle of incidence (%) | Transmittance at 10° angle of incidence (%) | Transmittance at 20° angle of incidence (%) | Transmittance at 30° angle of incidence (%) | Transmittance at 40° angle of incidence (%) |
|---|---|---|---|---|---|---|
| Example 1 | 558 | 98.6 | 98.9 | 95.0 | 88.6 | 97.7 |
| Example 2 | 562 | 99.5 | 99.1 | 95.5 | 88.3 | 98.2 |
| Example 3 | 352 | 98.8 | 99.2 | 98.6 | | |
| Example 4 | 282 | 99.7 | 99.9 | 99.2 | | |
| Example 5 | 141 | 99.8 | 99.9 | 99.9 | | |
| Comparative Example 1 | 591 | 90.6 | 90.5 | 95.3 | 98.6 | 88.6 |
| Comparative Example 2 | 814 | 94.5 | 91.7 | 90.9 | 98.5 | 88.1 |
| Comparative Example 3 | 320 | 90.1 | 89.7 | 89.0 | | |
| Comparative Example 4 | 90 | | | | | |

As is evident from Table 1, a pellicle film with transmittance of 95% or above at angles of incidence of from 0° to 20° was obtained in the cases of film thicknesses of 558 nm (Example 1), 562 nm (Example 2), 352 nm (Example 3), 282 nm (Example 4) and 141 nm (Example 5), which satisfy Equations (1)-(4).

On the other hand, in the cases of film thicknesses of 591 nm (Comparative Example 1), 814 nm (Comparative Example 2) and 320 nm (Comparative Example 3), which do not satisfy Equations (1)-(4), transmittance of 95% or above at angles of incidence of from 0° to 20° was not achieved. When the film thickness was further reduced to 90 nm, it was difficult to form a self-supporting film (Comparative Example 4).

In immersion exposure devices with a numerical aperture of 1.2 such as are currently under development, in which the maximum angle of incidence with respect to the pellicle is 17.5°, a pellicle with high transmittance in the range of angles of incidence of 17.5° and below can be favorably used.

The fluctuation in the transmittance with respect to the angle of incidence is due to interferential action of the thin film. The pellicle film with a thickness of 558 nm in Example 1 exhibited transmittance of 98% at an angle of incidence of 0°, and when the angle of incidence was 10°, the transmittance was even increased. Thereafter, the transmittance decreases from 20° to 30°, but increases again at 40°, which is thought to be due to a reduction in reflection caused by interference.

**Claims**

1. A pellicle (dust-proof cover) used in semiconductor lithography including a pellicle film (dust-proof film) attached to a frame, the pellicle being for use in an exposure device having a numerical aperture of not less than 1.0, wherein the pellicle has light transmittance at a wavelength of an exposure light source of 95% or more, at angles of incidence with respect to the pellicle film of from 0° to 20°.

2. The pellicle of claim 1, wherein the wavelength of the exposure light source is 200 nm or less.

3. The pellicle of claim 1 or claim 2, wherein the thickness of the pellicle film satisfies the following Equations (1)-(4):

$$\text{Equation (1): } \delta = 2\Pi \cdot n \cdot d \cdot \cos\theta/\lambda$$

$$\text{Equation (2): } T = 16n^2/\{(1+n)^4+(1-n)^2(n-1)^2-2(n-1)^2(1+n)^2\cos2\delta\}$$

$$\text{Equation (3): } T \geq 95$$

$$\text{Equation (4): } 0 \leq \theta \leq 20$$

T: transmittance (%)
d: pellicle film thickness (nm)
$\lambda$: wavelength of light source for exposure (nm)
n: refractive index of pellicle film
$\theta$: angle of incidence (°).

4. The pellicle of any one of claims 1 to 3, wherein the pellicle film is formed from a non-crystalline fluorine resin.

5. The pellicle of any one of claims 1 to 4, wherein the exposure light source is ArF excimer laser.

6. The pellicle of claim 5, wherein the refractive index of the pellicle film is 1.34 and the thickness is 558 nm + 15 nm.

7. The pellicle of any one of claims 1 to 6, wherein the exposure device is an immersion exposure device.

FIG. 1

Thickness of pellicle film (nm)

- - - - Angle of incidence: 20°    ———— Angle of incidence: 0°

**INTERNATIONAL SEARCH REPORT**

| International application No. |
|---|
| PCT/JP2007/051520 |

A. CLASSIFICATION OF SUBJECT MATTER
*G03F1/14*(2006.01)i, *H01L21/027*(2006.01)i

According to International Patent Classification (IPC) or to both national classification and IPC

B. FIELDS SEARCHED

Minimum documentation searched (classification system followed by classification symbols)
G03F1/14, H01L21/027

Documentation searched other than minimum documentation to the extent that such documents are included in the fields searched
Jitsuyo Shinan Koho        1922-1996   Jitsuyo Shinan Toroku Koho   1996-2007
Kokai Jitsuyo Shinan Koho   1971-2007   Toroku Jitsuyo Shinan Koho   1994-2007

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2004-085639 A (Asahi Glass Co., Ltd.), 18 March, 2004 (18.03.04), Claims; Par. Nos. [0090], [0091] (Family: none) | 1-7 |
| A | JP 2004-226476 A (Asahi Glass Co., Ltd.), 12 August, 2004 (12.08.04), Claims (Family: none) | 1-7 |
| A | JP 2000-347388 A (Shin-Etsu Chemical Co., Ltd.), 15 December, 2000 (15.12.00), Page 1 & JP 3562790 B2 | 1-7 |

☒ Further documents are listed in the continuation of Box C.   ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search 19 April, 2007 (19.04.07) | Date of mailing of the international search report 01 May, 2007 (01.05.07) |
|---|---|
| Name and mailing address of the ISA/ Japanese Patent Office | Authorized officer |
| Facsimile No. | Telephone No. |

Form PCT/ISA/210 (second sheet) (April 2005)

**INTERNATIONAL SEARCH REPORT**

International application No.

PCT/JP2007/051520

C (Continuation). DOCUMENTS CONSIDERED TO BE RELEVANT

| Category* | Citation of document, with indication, where appropriate, of the relevant passages | Relevant to claim No. |
|---|---|---|
| A | JP 2000-275817 A (Shin-Etsu Chemical Co., Ltd.), 06 October, 2000 (06.10.00), Page 1 (Family: none) | 1-7 |
| A | JP 2000-258895 A (Shin-Etsu Chemical Co., Ltd.), 22 September, 2000 (22.09.00), Page 1 (Family: none) | 1-7 |
| A | JP 07-199451 A (Shin-Etsu Chemical Co., Ltd.), 04 August, 1995 (04.08.95), Page 1 & TW 294843 A | 1-7 |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001255643 A
- JP 2000347388 A
- JP 7199451 A
- JP 7220990 A
- JP 10303114 A